# EUROPEAN PATENT SPECIFICATION

(11) **EP 3 295 275 B1**
(45) Date of publication and mention of the grant of the patent: **09.11.2022**
(21) Application number: 16793222.7
(22) Date of filing: 05.05.2016
(51) Int. Cl.: G06F 1/20, G06F 1/26, G06F 1/30, G06F 1/324, H05K 7/20

(54) **MANAGING POWER IN A HIGH PERFORMANCE COMPUTING SYSTEM FOR RESILIENCY AND COOLING**
LEISTUNGSVERWALTUNG IN EINEM HOCHLEISTUNGSCOMPUTERSYSTEM FÜR RESILIENZ UND KÜHLUNG
GESTION D'ÉNERGIE ÉLECTRIQUE DANS UN SYSTÈME INFORMATIQUE À HAUTES PERFORMANCES POUR RÉSILIENCE ET REFROIDISSEMENT

(30) Priority: 11.05.2015 US 201514709201; 01.06.2015 US 201562169058 P
(43) Date of publication of application: 21.03.2018
(73) Proprietor: Hewlett Packard Enterprise Development LP, Houston, TX 77070 (US)
(72) Inventor: GOH, Eng Lim, Milpitas, CA 95035 (US); DONLIN, Patrick, Deephaven, MN 55391 (US); WARNER, Andrew, Edina, MN 55416 (US)
(74) Representative: Marks & Clerk LLP
(86) International application number: PCT/US2016/031001
(87) International publication number: WO 2016/182851

(56) References cited:
- EP-A2- 2 386 932
- US-A1- 2004 268 166
- US-A1- 2010 235 003
- US-A1- 2010 235 003
- US-A1- 2013 139 896
- US-B1- 8 601 287
- US-B2- 7 210 048

## Description

### FIELD OF THE INVENTION

The invention generally relates to high performance computing systems and, more particularly, the invention relates to managing power in a high performance computing system.

### BACKGROUND OF THE INVENTION

In distributed processing systems, multiple processors communicate with each other and with memory devices to perform a shared computation. Because the types of computations involved are generally very complex or require a great deal of processing power, this type of communication often must be very high speed.

High-performance computing ("HPC") systems further increase speed by using specialized hardware that is not generally available commercially off-the-shelf for use in, for example, desktop or server computers. This specialized hardware often includes a plurality of computing nodes having customized application-specific integrated circuits ("ASICs") with a number of communications channels for communicating with other ASICS on other nodes (and components on the same node). Such hardware also includes the processors, memory, and other specialized hardware unique to implement a tightly-coupled HPC system. HPC systems thus often divide execution of complex computations across multiple of these interconnected nodes.

HPC systems produce significant amounts of heat. As such, proper cooling is important to their effective functioning. HPC systems also are prone to error conditions that can impair their ability to complete a task.

US2010/0235003 discloses an infrastructure for adaptive environmental control for equipment in a bounded area. US2004/0268166 discloses controlling power consumption of at least one computer system. US2013/0139896 discloses managing waste water discharge of a computing system. EP2386932 discloses a local cooling unit and cooling system.

### SUMMARY OF VARIOUS EMBODIMENTS

In accordance with the invention, there is provided a system comprising a high performance computing system, a cooling system, and an apparatus for thermally managing the high performance computing system, and a method of thermally managing the high performance computing system according to the appended claims. Embodiments or examples described below which are not within the scope of the claims are not encompassed by the invention.

To that end, the apparatus and method monitor the temperature of at least one of a) the environment of the high performance computing system and b) at least a portion of the high performance computing system. In response, the apparatus and method control the processing speed of at least one of the microprocessors on at least one of the plurality of nodes as a function of at least one of the monitored temperatures.

The high performance computing system may be located within a room having an air temperature. In that case, the environment may include a region of the room (e.g., the region near the computer system), and the monitored temperature may include the air temperature at the region of the room. Alternatively or additionally, the method may monitor at least one of microprocessors, memory, and power supplies of at least one of the nodes of the high performance computing system.

Among other ways, the temperature may be monitored by monitoring the temperature of both a) the environment of the high performance computing system and b) at least the portion of the high performance computing system. In that case, the method and apparatus may control the processing speed of at least one of the microprocessors on at least one of the plurality of nodes as a function of both the monitored temperatures (a) and (b).

Various embodiments control processor speeds based on a number of variables. For example, the method and apparatus may reduce the processing speed of the at least one microprocessor for a prescribed period of time, and then increase the speed of the at least one microprocessor after the prescribed period of time has elapsed. As another example, the method and apparatus may reduce the processing speed at least until the monitored temperature decreases to a prescribed temperature, and then increase the processing speed after the monitored temperature has decreased to the prescribed temperature.

To cool the nodes, the cooling system comprises a coil, the cooling system configured to selectively cool the coil in any one of a plurality of modes, the modes including a dry cooling mode that blows air on the coil and a wet cooling mode that sprays the coil with water. With such a system, the method and apparatus reduce the processing speed to a lower speed in response to the monitored temperature, and cool the coil with the dry cooling system after first reducing. Next, after reducing the processing speed and using the dry cooling system, the method switches the cooling system to the wet cooling mode and cools the coil with the wet cooling system if the monitored temperature continues to rise and exceeds a prescribed amount. The processing speed at this point is no greater than the lower speed when using the wet cooling system. Thus, according to the invention, if the dry cooling system has not been able to cool the coil sufficiently given certain performance parameters, it is caused to switch to the wet cooling system. Reducing the processing speed may, in some cases, eliminate the need for the wet cooling system so long as the monitored temperature remains at a prescribed level.

The noted cooling system thus is considered to cool in a plurality of modes-a lower cooling mode and a higher cooling mode. To conserve water, the method and apparatus may determine the cooling capacity of the lower cooling mode, and control/vary the processing speed of the at least one microprocessor to maintain the cooling system in the lower cooling mode. Among other ways, the method and apparatus may determine the cooling capacity by monitoring the temperature of at least a portion of the high performance computing system.

The apparatus for thermally managing the high performance computing system has a temperature sensor configured to monitor the temperature of at least one of a) the environment of the high performance computing system and b) at least a portion of the high performance computing system. The high performance computing system has a plurality of nodes with microprocessors. The apparatus also has a processor controller operatively coupled with the temperature monitor. The processor controller is configured to control the processing speed of one of the microprocessors on at least one of the plurality of nodes as a function of at least one of the monitored temperatures.

Illustrative embodiments of the invention are implemented as a computer program product having a computer usable medium with computer readable program code thereon. The computer readable code may be read and utilized by a computer system in accordance with conventional processes.

### BRIEF DESCRIPTION OF THE DRAWINGS

Those skilled in the art should more fully appreciate advantages of various embodiments of the invention from the following "DETAILED DESCRIPTION" discussed with reference to the drawings summarized immediately below.
Figure 1 schematically shows a logical view of an HPC system that may be used with illustrative embodiments of the present invention.
Figure 2 schematically shows a physical view of the HPC system of FIG. 1.
Figure 3 schematically shows details of a blade chassis of the HPC system of FIG. 1.
Figure 4 schematically shows another representation of a plurality of nodes in the high-performance computing system of FIG. 1
Figure 5 schematically shows another view of one of the nodes of FIG. 4.
Figure 6 shows a non-claimed example of a process of managing power consumption in a high-performance computing system that may be used with illustrative embodiments of the invention.
Figure 7 schematically shows a view of a room having a high performance computing system and an apparatus for managing power consumption of the high performance computing system in accordance with various embodiments of the invention.
Figure 8 shows a process of managing the thermal profile of a high-performance computing system in accordance with illustrative embodiments of the invention.
Figure 9 shows a non-claimed example of a process of managing errors of a high-performance computing system that may be used with illustrative embodiments of the invention.

### DETAILED DESCRIPTION

In accordance with the invention, there is provided a system comprising a high performance computing system, a cooling system, and an apparatus for thermally managing the high performance computing system, and a method of thermally managing the high performance computing system according to the appended claims. The apparatus manages power of the nodes in a high-performance computing system as a function of various environmental and/or performance criteria. To that end, a processor controller selectively reduces the power usage of one or more nodes to reduce water consumption required by a wet cooling system or a hybrid cooling system. When controlled appropriately, the apparatus may mitigate or substantially eliminate the need for wet cooling systems and, in some instances, expensive chillers. In fact, the apparatus may reduce power usage if it detects a malfunction in the cooling system itself. Accordingly, if the cooling system is unable to adequately cool the system, the processor controller may reduce power consumption to mitigate the chance of system overheating.

In a non-claimed example useful for understanding the present invention, after detecting error conditions in a high-performance computing system, a processor controller reduces the processing speed of one or more of its nodes. For example, the controller may permit some or all currently executing processes to conclude (or reach an appropriate stopping point) before shutting down some or all of the system for service, or performing a hot-swapping operation. While enabling processes to conclude or reach an appropriate stopping point, reducing the processing speed should increase the likelihood that the system does not fail before it can be serviced. This controlled reduction in speed to an ultimate service helps maintain the resiliency and efficiency of the system.

In a non-claimed example useful for understanding the present invention, an application program executing on a high performance computing system dynamically varies its permitted power range. To that end, using information related to a plurality of nodes in the system, a central controller sets an initial power range for the system. The application, which is configured to execute on a subset of the plurality of nodes (i.e., it executes on one or more nodes of the system), also initially is intended to follow this initial power range. In response to changing or unique requirements, however, the application program can request a new/different power range for its nodes. In fact, the application program can request this different power range even before receiving the initial power range.

The central controller of this latter example thus may change the power range of the one or more nodes executing the application program. As such, one or more nodes subsequently use that new power range to execute the processes required by the application program. Such dynamic power control can more efficiently coordinate power usage and processing among the plurality of nodes in the system, effectively improving overall system performance.

Details of these and other embodiments are discussed below.

### System Architecture

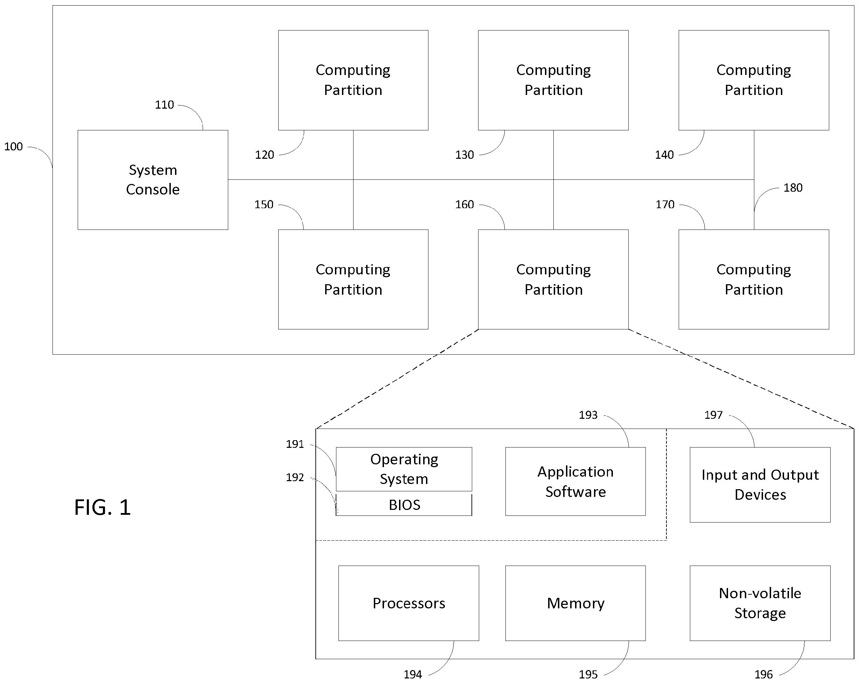

Figure 1 schematically shows a logical view of an exemplary high-performance computing system **100** that may be used with illustrative embodiments of the present invention. Specifically, as known by those in the art, a "high-performance computing system," or "HPC system," is a computing system having a plurality of modular computing resources that are tightly coupled using hardware interconnects, so that processors may access remote data directly using a common memory address space.

The HPC system **100** includes a number of logical computing partitions **120**, **130**, **140**, **150**, **160**, **170** for providing computational resources, and a system console **110** for managing the plurality of partitions **120-170**. A "computing partition" (or "partition") in an HPC system is an administrative allocation of computational resources that runs a single operating system instance and has a common memory address space. Partitions **120-170** may communicate with the system console **110** using a logical communication network **180**. A system user, such as a scientist or engineer who desires to perform a calculation, may request computational resources from a system operator, who uses the system console **110** to allocate and manage those resources. Allocation of computational resources to partitions is described below. The HPC system **100** may have any number of computing partitions that are administratively assigned as described in more detail below, and often has only one partition that encompasses all of the available computing resources. Accordingly, this figure should not be seen as limiting the scope of the invention.

Each computing partition, such as partition **160**, may be viewed logically as if it were a single computing device, akin to a desktop computer. Thus, the partition **160** may execute software, including a single operating system ("OS") instance **191** that uses a basic input/output system ("BIOS") **192** as these are used together in the art, and application software **193** for one or more system users.

Accordingly, as also shown in FIG. 1, a computing partition has various hardware allocated to it by a system operator, including one or more processors **194**, volatile memory **195**, non-volatile storage **196**, and input and output ("I/O") devices **197** (e.g., network ports, video display devices, keyboards, and the like). However, in HPC systems like in FIG. 1, each computing partition has a great deal more processing power and memory than a typical desktop computer. The OS software may include, for example, a Windows^{®} operating system by Microsoft Corporation of Redmond, Wash., or a Linux operating system. Moreover, although the BIOS may be provided as firmware by a hardware manufacturer, such as Intel Corporation of Santa Clara, Calif., it is typically customized according to the needs of the HPC system designer to support high-performance computing, as described below in more detail.

As part of its system management role, the system console **110** acts as an interface between the computing capabilities of the computing partitions **120-170** and the system operator or other computing systems. To that end, the system console **110** issues commands to the HPC system hardware and software on behalf of the system operator that permit, among other things: 1) booting the hardware, 2) dividing the system computing resources into computing partitions, 3) initializing the partitions, 4) monitoring the health of each partition and any hardware or software errors generated therein, 5) distributing operating systems and application software to the various partitions, 6) causing the operating systems and software to execute, 7) backing up the state of the partition or software therein, 8) shutting down application software, and 9) shutting down a computing partition or the entire HPC system **100**. These particular functions are described in more detail in the section below entitled "System Operation."

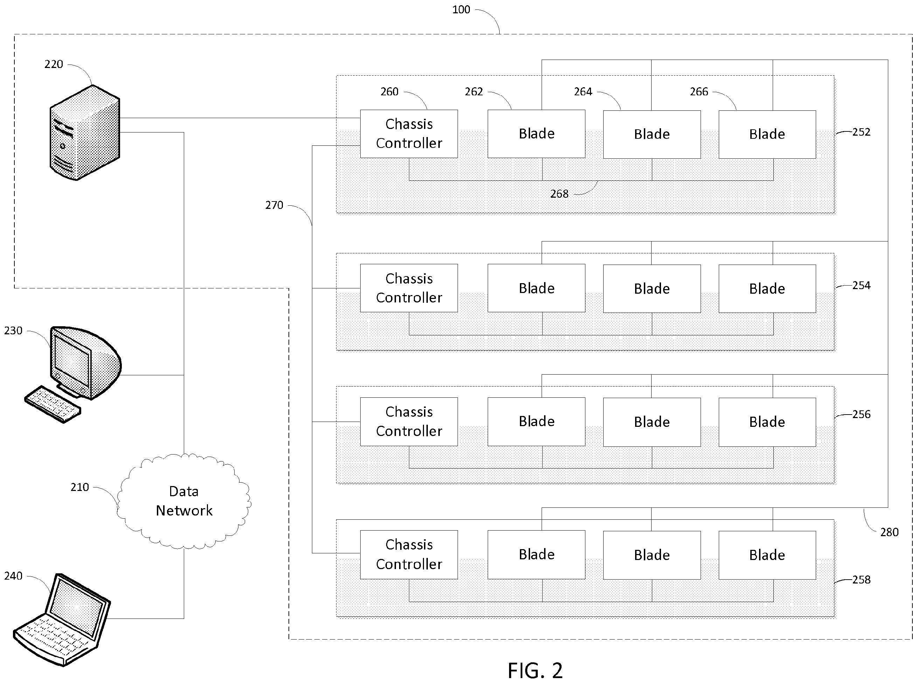

FIG. 2 schematically shows a physical view of a high performance computing system **100** in accordance with FIG. 1. The hardware that comprises the HPC system **100** of FIG. 1 is surrounded by the dashed line. The HPC system **100** is connected to a customer data network **210** to facilitate customer access.

The HPC system **100** includes a system management node ("SMN") **220** that performs the functions of the system console **110**. The management node **220** may be implemented as a desktop computer, a server computer, or other similar computing device, provided either by the customer or the HPC system designer, and includes software necessary to control the HPC system **100** (i.e., the system console software).

The HPC system **100** is accessible using the data network **210**, which may include any data network known in the art, such as a customer local area network ("LAN"), a virtual private network ("VPN"), the Internet, or the like, or a combination of these networks. Any of these networks may permit a number of users to access the HPC system resources remotely and/or simultaneously. For example, the management node **220** may be accessed by a customer computer **230** by way of remote login using tools known in the art such as Windows^{®} Remote Desktop Services or the UNIX secure shell. If the customer is so inclined, access to the HPC system **100** may be provided to a remote computer **240**. The remote computer **240** may access the HPC system by way of a login to the management node **220** as just described, or using a gateway or proxy system as is known to persons in the art.

The hardware computing resources of the HPC system **100** (e.g., the processors, memory, non-volatile storage, and I/O devices shown in FIG. 1) are provided collectively by one or more "blade chassis," such as blade chassis **252**, **254**, **256**, **258** shown in FIG. 2, that are managed and allocated into computing partitions. A blade chassis is an electronic chassis that is configured to house, power, and provide high-speed data communications between a plurality of stackable, modular electronic circuit boards called "blades." Each blade includes enough computing hardware to act as a standalone computing server. The modular design of a blade chassis permits the blades to be connected to power and data lines with a minimum of cabling and vertical space.

Accordingly, each blade chassis, for example blade chassis **252**, has a chassis management controller 260 (also referred to as a "chassis controller" or "CMC") for managing system functions in the blade chassis **252**, and a number of blades **262**, **264**, **266** for providing computing resources. Each blade, for example blade **262**, contributes its hardware computing resources to the collective total resources of the HPC system **100**. The system management node **220** manages the hardware computing resources of the entire HPC system **100** using the chassis controllers, such as chassis controller **260**, while each chassis controller in turn manages the resources for just the blades in its blade chassis. The chassis controller **260** is physically and electrically coupled to the blades **262-266** inside the blade chassis **252** by means of a local management bus **268**, described below in more detail. The hardware in the other blade chassis **254-258** is similarly configured.

The chassis controllers communicate with each other using a management connection **270**. The management connection **270** may be a high-speed LAN, for example, running an Ethernet communication protocol, or other data bus. By contrast, the blades communicate with each other using a computing connection **280**. To that end, the computing connection **280** illustratively has a high-bandwidth, low-latency system interconnect, such as NumaLink, developed by Silicon Graphics International Corp. of Milpitas, Calif.

The chassis controller **260** provides system hardware management functions to the rest of the HPC system. For example, the chassis controller **260** may receive a system boot command from the SMN **220**, and respond by issuing boot commands to each of the blades **262-266** using the local management bus **268**. Similarly, the chassis controller **260** may receive hardware error data from one or more of the blades **262-266** and store this information for later analysis in combination with error data stored by the other chassis controllers. In some systems, such as that shown in FIG. 2, the SMN **220** or a customer computer **230** are provided access to a single, master chassis controller **260** that processes system management commands to control the HPC system **100** and forwards these commands to the other chassis controllers. In other systems, however, an SMN **220** is coupled directly to the management connection **270** and issues commands to each chassis controller individually. Persons having ordinary skill in the art may contemplate variations of these designs that permit the same type of functionality, but for clarity only these designs are presented.

The blade chassis **252**, its blades **262-266**, and the local management bus **268** may be provided as known in the art. However, the chassis controller **260** may be implemented using hardware, firmware, or software provided by the HPC system designer. Each blade provides the HPC system **100** with some quantity of processors, volatile memory, non-volatile storage, and I/O devices that are known in the art of standalone computer servers. However, each blade also has hardware, firmware, and/or software to allow these computing resources to be grouped together and treated collectively as computing partitions, as described below in more detail in the section entitled "System Operation."

While FIG. 2 shows an HPC system **100** having four chassis and three blades in each chassis, it should be appreciated that these figures do not limit the scope of the invention. An HPC system may have dozens of chassis and hundreds of blades; indeed, HPC systems often are desired because they provide very large quantities of tightly-coupled computing resources.

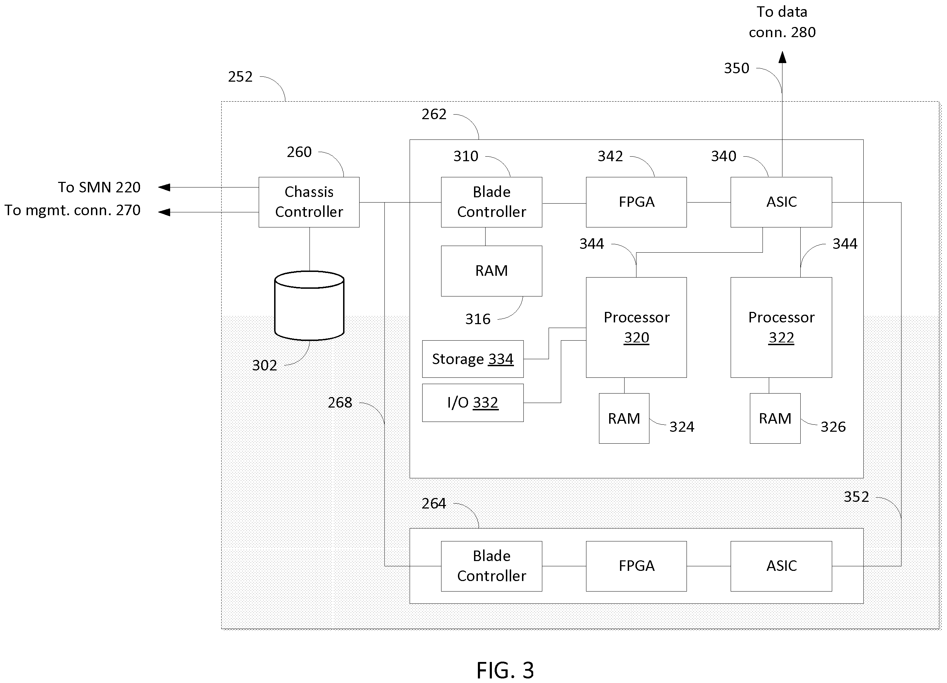

FIG. 3 schematically shows a single blade chassis **252** in more detail. In this figure, parts not relevant to the immediate description have been omitted. The chassis controller **260** is shown with its connections to the system management node **220** and to the management connection **270**. The chassis controller **260** may be provided with a chassis data store **302** for storing chassis management data. In some embodiments, the chassis data store **302** is volatile random access memory ("RAM"), in which case data in the chassis data store **302** are accessible by the SMN **220** so long as power is applied to the blade chassis **252**, even if one or more of the computing partitions has failed (e.g., due to an OS crash) or a blade has malfunctioned. In other embodiments, the chassis data store **302** is non-volatile storage such as a hard disk drive ("HDD") or a solid state drive ("SSD"). In these embodiments, data in the chassis data store **302** are accessible after the HPC system has been powered down and rebooted.

FIG. 3 shows relevant portions of specific implementations of the blades **262** and **264** for discussion purposes. The blade **262** includes a blade management controller **310** (also called a "blade controller" or "BMC") that executes system management functions at a blade level, in a manner analogous to the functions performed by the chassis controller at the chassis level. For more detail on the operations of the chassis controller and blade controller, see the section entitled "HPC System Operation" below. The blade controller **310** may be implemented as custom hardware, designed by the HPC system designer to permit communication with the chassis controller **260**. In addition, the blade controller **310** may have its own RAM **316** to carry out its management functions. The chassis controller **260** communicates with the blade controller of each blade using the local management bus **268**, as shown in FIG. 3 and the previous figures.

The blade **262** also includes one or more microprocessors **320**, **322** (alternatively referred to as "processors **320** or **322**" or generically referred to as "processors **320**") that are connected to RAM **324**, **326**. Blade **262** may be alternately configured so that multiple processors may access a common set of RAM on a single bus, as is known in the art. It should also be appreciated that processors **320**, **322** may include any number of central processing units ("CPUs") or cores, as is known in the art. The processors **320**, **322** in the blade **262** are connected to other items, such as a data bus that communicates with I/O devices **332**, a data bus that communicates with non-volatile storage **334**, and other buses commonly found in standalone computing systems. (For clarity, FIG. 3 shows only the connections from processor **320** to these other devices.) The processors **320**, **322** may be, for example, Intel^{®} Core^{™} processors manufactured by Intel Corporation. The I/O bus may be, for example, a PCI or PCI Express ("PCIe") bus. The storage bus may be, for example, a SATA, SCSI, or Fibre Channel bus. It will be appreciated that other bus standards, processor types, and processor manufacturers may be used in accordance with illustrative embodiments of the present invention.

Each blade (e.g., the blades **262** and **264**) includes an application-specific integrated circuit **340** (also referred to as an "ASIC", "hub chip", or "hub ASIC") that controls much of its functionality. More specifically, to logically connect the processors **320**, **322**, RAM **324**, **326**, and other devices **332**, **334** together to form a managed, multi-processor, (optionally) coherently-shared distributed-memory HPC system, the processors **320**, **322** are electrically connected to the hub ASIC **340**. The hub ASIC **340** thus provides an interface between the HPC system management functions generated by the SMN **220**, chassis controller **260**, and blade controller **310**, and the computing resources of the blade **262**.

In this connection, the hub ASIC **340** connects with the blade controller **310** either through a direct connection, or by way of a field-programmable gate array ("FPGA") **342** or similar programmable device for passing signals between integrated circuits. Those skilled in the art can select the appropriate connection between the hub ASIC **340** and the blade controller **310**. Discussion of the direct connection or indirect connection should not limit various embodiments of the invention.

In particular, signals are generated on output pins of the blade controller **310**, in response to commands issued by the chassis controller **260**. In the indirect connection case, these signals are translated by the FPGA **342** into commands for certain input pins of the hub ASIC **340**, and vice versa. For example, a "power on" signal received by the blade controller **310** from the chassis controller **260** requires, among other things, providing a "power on" voltage to a certain pin on the hub ASIC **340**; the FPGA **342** facilitates this task.

The field-programmable nature of the FPGA **342** permits the interface between the blade controller **310** and ASIC **340** to be reprogrammable after manufacturing. Thus, for example, the blade controller **310** and ASIC **340** may be designed to have certain generic functions, and the FPGA **342** may be used advantageously to program the use of those functions in an application-specific way. The communications interface between the blade controller **310** and ASIC **340** also may be updated if a hardware design error is discovered in either module, permitting a quick system repair without requiring new hardware to be fabricated.

Also in connection with its role as the interface between computing resources and system management, the hub ASIC **340** is connected to the processors **320**, **322** by way of a high-speed processor interconnect **344**. The processors **320**, **322** may be manufactured by Intel Corporation which provides the Intel^{®} QuickPath Interconnect ("QPI") for this purpose, and the hub ASIC **340** includes a module for communicating with the processors **320**, **322** using QPI. Other processor interconnect configurations may be used.

The hub chip **340** in each blade also provides connections to other blades for high-bandwidth, low-latency data communications. Thus, the hub chip **340** includes a link **350** to the computing connection **280** that connects different blade chassis. This link **350** may be implemented using networking cables, for example. The hub ASIC **340** also includes connections to other blades in the same blade chassis **252**. The hub ASIC **340** of blade **262** connects to the hub ASIC **340** of blade **264** by way of a chassis computing connection **352**. The chassis computing connection **352** may be implemented as a data bus on a backplane of the blade chassis **252** rather than using networking cables, advantageously allowing the very high speed data communication between blades that is required for high-performance computing tasks. Data communication on both the inter-chassis computing connection **280** and the intra-chassis computing connection **352** may be implemented using the NumaLink protocol or a similar protocol.

### HPC System Operation

System management commands generally propagate from the SMN **220**, through the management connection **270** to the blade chassis (and their chassis controllers), then to the blades (and their blade controllers), and finally to the hub ASICS that implement the commands using the system computing hardware.

As a concrete example, consider the process of powering on an HPC system. In accordance with exemplary embodiments, the HPC system **100** is powered when a system operator issues a "power on" command from the SMN **220**. The SMN **220** propagates this command to each of the blade chassis **252-258** by way of their respective chassis controllers, such as chassis controller **260** in blade chassis **252**. Each chassis controller, in turn, issues a "power on" command to each of the respective blades in its blade chassis by way of their respective blade controllers, such as blade controller **310** of blade **262**. Blade controller **310** issues a "power on" command to its corresponding hub chip **340** using the FPGA **342**, which provides a signal on one of the pins of the hub chip **340** that allows it to initialize. Other commands propagate similarly.

Once the HPC system is powered on, its computing resources may be divided into computing partitions. The quantity of computing resources that are allocated to each computing partition is an administrative decision. For example, a customer may have a number of projects to complete, and each project is projected to require a certain amount of computing resources. Different projects may require different proportions of processing power, memory, and I/O device usage, and different blades may have different quantities of the resources installed. The HPC system administrator takes these considerations into account when partitioning the computing resources of the HPC system **100**. Partitioning the computing resources may be accomplished by programming each blade's RAM **316**. For example, the SMN **220** may issue appropriate blade programming commands after reading a system configuration file.

The collective hardware computing resources of the HPC system **100** may be divided into computing partitions according to any administrative need. Thus, for example, a single computing partition may include the computing resources of some or all of the blades of one blade chassis **252**, all of the blades of multiple blade chassis **252** and **254**, some of the blades of one blade chassis **252** and all of the blades of blade chassis **254**, all of the computing resources of the entire HPC system **100**, and other similar combinations. Hardware computing resources may be partitioned statically, in which case a reboot of the entire HPC system **100** is required to reallocate hardware. Alternatively and preferentially, hardware computing resources are partitioned dynamically while the HPC system **100** is powered on. In this way, unallocated resources may be assigned to a partition without interrupting the operation of other partitions.

It should be noted that once the HPC system **100** has been appropriately partitioned, each partition may be considered to act as a standalone computing system. Thus, two or more partitions may be combined to form a logical computing group inside the HPC system **100**. Such grouping may be necessary if, for example, a particular computational task is allocated more processors or memory than a single operating system can control. For example, if a single operating system can control only 64 processors, but a particular computational task requires the combined power of 256 processors, then four partitions may be allocated to the task in such a group. This grouping may be accomplished using techniques known in the art, such as installing the same software on each computing partition and providing the partitions with a VPN.

Once at least one partition has been created, the partition may be booted and its computing resources initialized. Each computing partition, such as partition **160**, may be viewed logically as having a single OS **191** and a single BIOS **192**. As is known in the art, BIOS is a collection of instructions that electrically probes and initializes the available hardware to a known state so that the OS can boot, and is typically provided in a firmware chip on each physical server. However, a single logical computing partition **160** may span several blades, or even several blade chassis. A blade may be referred to as a "computing node" or simply a "node" to emphasize its allocation to a particular partition.

Booting a partition in accordance with an embodiment of the invention requires a number of modifications to be made to a blade chassis that is purchased from stock. In particular, the BIOS in each blade are modified to determine other hardware resources in the same computing partition, not just those in the same blade or blade chassis. After a boot command has been issued by the SMN **220**, the hub ASIC **340** eventually provides an appropriate signal to the processor **320** to begin the boot process using BIOS instructions. The BIOS instructions, in turn, obtain partition information from the hub ASIC **340** such as: an identification (node) number in the partition, a node interconnection topology, a list of devices that are present in other nodes in the partition, a master clock signal used by all nodes in the partition, and so on. Armed with this information, the processor **320** may take whatever steps are required to initialize the blade **262**, including 1) non-HPC-specific steps such as initializing I/O devices **332** and non-volatile storage **334**, and 2) also HPC-specific steps such as synchronizing a local hardware clock to a master clock signal, initializing HPC-specialized hardware in a given node, managing a memory directory that includes information about which other nodes in the partition have accessed its RAM, and preparing a partition-wide physical memory map.

At this point, each physical BIOS has its own view of the partition, and all of the computing resources in each node are prepared for the OS to load. The BIOS then reads the OS image and executes it, in accordance with techniques known in the art of multiprocessor systems. The BIOS presents to the OS a view of the partition hardware as if it were all present in a single, very large computing device, even if the hardware itself is scattered among multiple blade chassis and blades. In this way, a single OS instance spreads itself across some, or preferably all, of the blade chassis and blades that are assigned to its partition. Different operating systems may be installed on the various partitions. If an OS image is not present, for example immediately after a partition is created, the OS image may be installed using processes known in the art before the partition boots.

Once the OS is safely executing, its partition may be operated as a single logical computing device. Software for carrying out desired computations may be installed to the various partitions by the HPC system operator. Users may then log into the SMN 220. Access to their respective partitions from the SMN 220 may be controlled using volume mounting and directory permissions based on login credentials, for example. The system operator may monitor the health of each partition, and take remedial steps when a hardware or software error is detected. The current state of long-running application programs may be saved to non-volatile storage, either periodically or on the command of the system operator or application user, to guard against losing work in the event of a system or application crash. The system operator or a system user may issue a command to shut down application software. Other operations of an HPC partition may be known to a person having ordinary skill in the art. When administratively required, the system operator may shut down a computing partition entirely, reallocate or deallocate computing resources in a partition, or power down the entire HPC system **100**.

### General Power Management

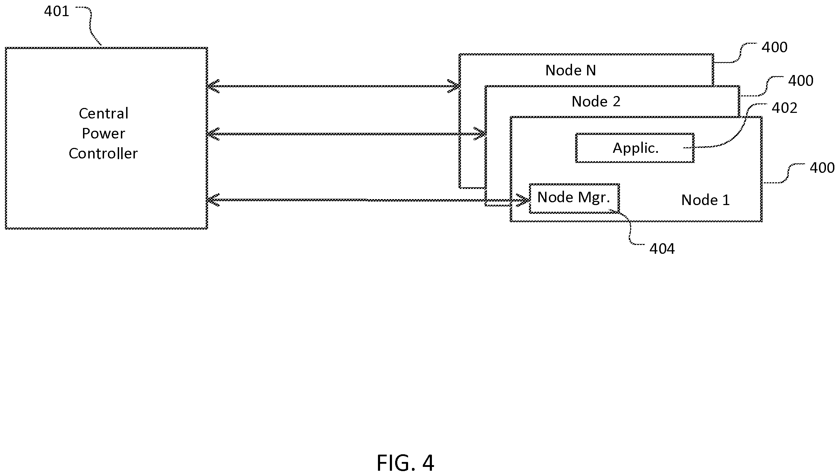

As noted above, the system may manage node power to ensure a more efficient and effective operation. To that end, FIG. 4 schematically shows another representation of a plurality of nodes (identified below as "nodes **400**") in the high-performance computing system **100** of FIG. 1. Specifically, this figure shows a plurality of nodes **400**, labeled as Node **1**, Node **2** ... Node N, that communicate with a central power controller **401** to coordinate their power needs. In other words, as discussed in greater detail below, after collecting the relevant system information, the central power controller **401** sets a power range in which the nodes **400** are required to operate. Alternatively the system may simply run the nodes **400** at a default power range.

In illustrative embodiments, the central power controller **401** is implemented separately from the nodes **400** and thus, has independent components, such as independent boards (e.g., motherboards, daughterboards, etc.), microprocessors, memory, etc. For example, the central power controller **401** may be implemented at least in part as a system management controller ("SMC," distributed by Intel Corporation of Santa Clara, Calif.), which controls power use in computer systems. The nodes **400** communicate with the central power controller **401** using any of the above noted interconnection mechanisms.

In addition to the components described in prior sections of this description for each node **400**, this representation simply shows each node **400** executing an application program (referred to below as "application program **402**"), and having a node manager **404** for managing its power functionality. Although showing only one application program **402**, this figure should be considered to represent pluralities of application programs **402** that each execute across one or more of any of the nodes **400**. For example, the first application program **402** may execute across Nodes **1**, **3**, and **44**, while a second application may execute on Node **1** only, and a third application program **402** may execute across Nodes **3**, **5**, and **10-60**. Accordingly, discussion of a single application executing on one or a few nodes is for simplicity purposes only.

Each node manager **404**, which may be implemented as part of the hub ASIC **340** or as another component, preferably has a prescribed set of power management functions. To that end, each node manager **404** may be considered to be a dedicated management device on each node **400**. As a functional module that communicates via the management network of the HPC **100**, each node manager **404** measures and controls node power, provides power and usage statistics, and manages and enforces power policies. The node manager **404** thus can read an average power from power supplies, reduce/increase power draw to the processors by reducing/increasing processor frequencies, and regulate power and frequency to a target limit. For example, the node manager **404** can manage and enforce power policies set by the central power controller **401**.

Indeed, it should be noted that, like FIGS. 1-3 and 5 (discussed below) FIG. 4 only schematically generically shows certain components. Those skilled in the art should understand that each of these components can be implemented in a variety of conventional manners, such as by using hardware, software, or a combination of hardware and software, across one or more other functional components. For example, the central power controller **401** may be implemented using a plurality of microprocessors executing firmware. As another example, the central power controller **401** may be implemented using one or more application specific integrated circuits (i.e., "ASICs") and related software, or a combination of ASICs, discrete electronic components (e.g., transistors), and microprocessors. Accordingly, the representation of the central power controller **401** and other components in a single box of FIG. 4 is for simplicity purposes only. In fact, in some embodiments, the central power controller **401** of FIG. 4 is distributed across a plurality of different machines-not necessarily within the same housing or chassis.

It should be reiterated that the schematic representation of components in these figures is a significantly simplified representation of an actual devices they represent. Those skilled in the art should understand that such devices may have many other physical and functional components. Accordingly, this discussion is in no way intended to suggest that these figures represents all of the elements of a component shown in the figures.

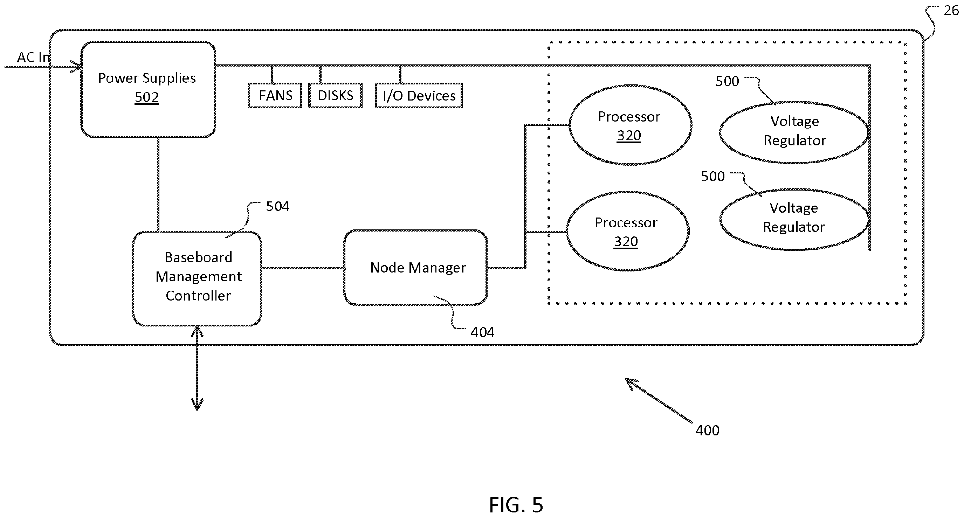

FIG. 5 schematically shows specific details of one of the nodes **400** of FIG. 4. In addition to showing the node manager **404**, this figure also shows the processors **320** and voltage regulators **500** that control the power used by each of the processors **320**. In addition, this figure also shows the power supply **502**, which measures the power and converts input AC power to DC output power for use by the voltage regulators **500**. The node **400** also has a baseboard management controller **504**, which connects to system management to facilitate reading, obtaining, and setting power limits/ranges.

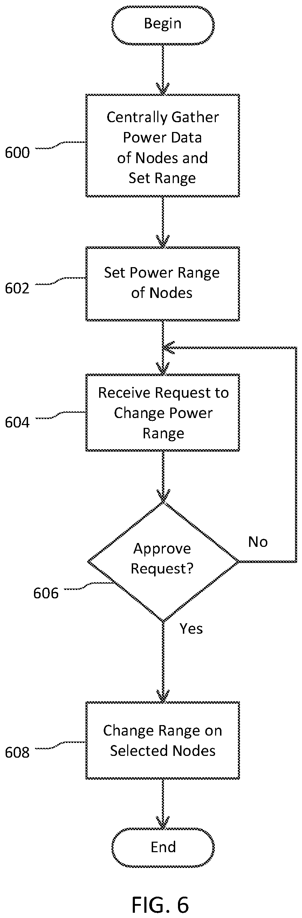

FIG. 6 shows a process of managing node power in the high-performance computing system **100** of FIG. 1. It should be noted that this process is substantially simplified from a longer process that normally would be used to manage power use by the nodes **400**. Accordingly, the process can have many steps, such as specific techniques for formulate appropriate power levels, which those skilled in the art likely would use. In addition, some of the steps may be performed in a different order than that shown, or at the same time. Those skilled in the art therefore can modify the process as appropriate.

The process of FIG. 6 begins at step **600**, in which the central power controller **401** gathers application information relating to the nodes **400** of the network that it manages. Among other things, the central power controller **401** may retrieve statistics, policies, and other relevant information from the node managers **404** on the plurality of nodes **400**.

Some embodiments may have a plurality of different central power controllers **400** that are each assigned to specific pluralities of nodes **400** within the HPC system **100** (e.g., nodes within the same blade). Other embodiments, however, may have a single central power controller **401** that manages all of the nodes **400** within the HPC system **100**. For simplicity purposes, this discussion only addresses a single central power controller **401** managing a plurality of nodes **400** of the HPC system **100**. This plurality of nodes **400** also includes a set of nodes **400** executing an application program **402**. This set of nodes **400** may include all of the plurality of nodes **400**, or some smaller number of nodes **400**. In fact, this set of nodes **400** can include a single node 400 executing a single application program **402**. Alternatively, the central controller **401** simply powers the nodes **400** at a default power.

After gathering the relevant information from the nodes, the central power controller **401** uses internal processes to set a prescribed power range for all of the nodes **400** it manages. In other words, using the gathered information, the central power controller **401** sets a centralized power range for the plurality of nodes **400**. The power range may have only a maximum power value. Accordingly, the nodes **400** managed by the central power controller **401** can run at powers up to the maximum power value. Other systems, however, may have ranges with both minimum and maximum power values.

Next, at **602**, the central power controller **401** centrally sets/mandates the power range of the nodes **400** to the specified range determined at step **600**. Illustrative systems may control power the number of ways, such as by limiting the clock speeds of the processors **322** resident in the nodes **400**. Among other ways, this new power range may be set for an indefinite time period, or set to last for a prescribed time, such as until receipt of another mandated power range or until some event occurs.

To that end, the central power controller **401** forwards a power setting message to the node managers **404** the plurality of nodes **400** it manages; in this way, the central power controller **401** requires each of those nodes **400** to operate within the centrally mandated prescribed range. The node managers **404** responsively store this information in memory and limit power to this range as specified in the message.

Accordingly, this step sets the power limits of the plurality of nodes **400** to the specified range. Such a power range, however, may not be optimal for some set of the nodes **400**, or all of the nodes **400**. Specifically, several of the nodes **400** running a given application program **402** may require more power at certain times to efficiently and effectively execute. In that case, the centrally mandated power may be too low, slowing the processors **322** for those several nodes **400** to a reduced clock speed that is insufficient for the task the application program **402** must complete. If the given application program **402** cannot use extra power (e.g., speeding up its processors **322**), then it may lag other threads/application programs **402** executing on the system, causing a number of local and systemic problems. For example, this delay can cause jitter the system, local and system errors, and generally slow processing.

To minimize the likelihood of those problems from occurring, illustrative systems permit a given application to operate at a power level that is different than that centrally mandated for the entire system. For example, the given application may operate at a power level for a prescribed time that is higher than that mandated for the nodes **400**.

More specifically, the given application typically is a reliable source of information about its power needs and can determine its power requirements. It thus can best make the determination about the optimal power required to efficiently and effectively complete processing. Accordingly, before, during, or after receipt of the centrally mandated power range from the central power controller **401**, the given application program **402** can request and receive approval for a different power range.

To that end, at step **604**, after determining its power needs, the given application program **402** generates a power command or request, which it forwards to the central power controller **401** for approval. Indeed, those in the art understand that this command may be forwarded between the application program **402** and central power controller **401** via a number of intervening functional modules. As such, there is no requirement that the application program **402** directly forward the power command to the central power controller **401**.

This power command has instructions specifically requesting that the central power controller **401** change the power range for the set of nodes **400** upon which it is executing. The central power controller **401** responsively determines at step **606** if it can in fact approve/grant the request. For example, while increased power may be beneficial for the set of nodes **400** running the given application program **402**, it may have an intolerably adverse impact on those or other nodes **400**/application programs **402** if granted. If that is the case, or there are other reasons for denying the request, then the process simply loops back to step **604** and does not approve the request. This denial may iterate indefinitely, or for a prescribed number of requests. The system administrator or other entity may set policies for approving requests and the number of requests it may receive.

Conversely, the central power controller **401** may approve the request and set an appropriate power under prescribed parameters. For example, the central power controller **401** may simply change the power range without any other changes to other requirements of the nodes **400**. Other systems may simply remove power limitations or restrictions, permitting the at least one node **400** to use whatever power it requires.

In some systems, however, to compensate for the increased power demands, the central power controller **401** may grant the request, but require that the application run at a lower power at certain times. For example, the central power controller **401** may grant increased power for prescribed times, but require that the total power used by the set of nodes **400** not exceed a prescribed total value. In this case, the application program **402** may have certain execution paths that require a minimal amount of power. When executing those paths, the application program **402** may be configured to use a lower amount of power than it originally intended to use. In this manner, the system can maintain consistent overall power demands while meeting periodic power spikes.

Accordingly, if the central power controller **401** approves the request at step **606**, then the process will change the power range on the set of nodes **400** running the application requesting the new power range. To that end, the central power controller **401** may forward a power change message to the node managers **404** of the affected set of nodes **400**. After receipt of the message, each node manager **404** adjusts its internal settings to operate within the parameters set by the central power controller **401**. As noted above, these parameters may include power values, times, and amounts of time to use the range. In fact, these parameters may include a plurality of different power ranges for different times. As also noted above, these different times can be set based upon events, specific times, or other bases as prescribed by those skilled in the art.

In some systems, if the application program **402** spans a plurality of nodes **400**, then it may make only one request to the central power controller **401** for a power change in one, some, or all of the nodes **400** in which it is executing. Other systems, however, may make multiple such requests.

This process of FIG. 6 can repeat to dynamically change the power range even after the application program **402** has initially changed the power ranges of its set of nodes **400**. Moreover, rather than having the application programs **402** determine and request power requirements, some systems may use other logic for controlling the power needs in the described manner. Such systems may be considered to cooperate with the application program **402** and effectively act as the application program **402**.

Illustrative systems therefore enable a given application program **402** to dynamically change its power requirements to optimize system performance. Accordingly, the given application may have the capability to operate at speeds that ensure coherency, efficiency, and overall effectiveness.

### Thermal Management

High-performance computing systems, such as the one described above, consume significant amounts of power and thus, generate correspondingly significant amounts of heat. Accordingly, those skilled in the art have developed a number of different techniques for cooling the heat generating components of the system (e.g., the processors **320**, memory **326**, etc.). One technique uses a closed loop channel containing liquid coolant (e.g., water) that absorbs heat from the heat generating elements, and cycles through a cooler portion of the environment, such as the outside of the building containing the computer system.

Cooler environments simply may channel coils carrying the liquid coolant past fans/blowers that blow cooler air on the coils, thus creating a convective cooling effect. Undesirably, such convective cooling systems (referred to as "dry cooling systems") may not provide sufficient cooling in warmer climates, or even on some days in cooler climates. To manage this problem, some systems use "wet cooling systems," which, in addition to blowing air onto the coils, typically spray water onto the coils for enhanced cooling. These systems thus often are referred to as "evaporative cooling systems." To get the benefits of both systems, some high-performance computing systems take a hybrid approach by using a "hybrid cooler," which operates either in a dry cooling mode (i.e., like a dry cooling system) or in a wet cooling mode (i.e., like a wet cooling system) when needed. For example, the majority of the time, the hybrid cooler may operate in a dry cooling mode, but switch to a wet cooling mode on certain unusually hotter days.

Many parts of the world, however, are in drought conditions or have significant water shortages. Many have predicted that water shortages will be a primary problem of the 21st-century. Accordingly, illustrative embodiments control the power consumption of the high-performance computing system to minimize the need to use more effective cooling processes (e.g., wet cooling processes). To that end, logic within the high-performance computing system preferably determines the thermal profile of the system and temporarily throttles back processor speed at prescribed times so that they do not require wet cooling processes. Although it is expected to slow overall system speed, it can reduce water demand from the cooling system.

For example, a hybrid cooling system may begin its wet cooling mode when the temperature detected in the environment or in a certain portion of the high-performance computing system meets or exceeds X degrees C. Accordingly, the central power controller **401** may manage the speed of the processors **320** within a node **400**, a blade, or the entire system in an effort to ensure that the noted temperature does not exceed X degrees C. Specifically, reducing the speed of the processors **320** typically reduces the heat they generate. Stated another way, supplying less power to the processors **320** causes them to generate less heat.

Among other ways to accomplish these goals, the central power controller **401** (or other system logic) may incrementally reduce the processor speed (e.g., by increments of one percent or by uneven increments), and periodically check the temperature of some system related area using a closed loop process. Other embodiments may simply program the power controller **400** to reduce the processor speeds to a prescribed lower speed for a prescribed time. To operate effectively, these latter embodiments likely require some predictive knowledge of the behavior of the system, and anticipated temperatures. As noted above, the processor speeds can be controlled at the node level (e.g., within one or more of the processors **320** in a given node **400**), the blade level, the rack level, system-level, or an entire data center level.

Indeed, those skilled in the art may apply other techniques for managing the system power. For example, during a hot day, some or all of the system may be subject to a strict power limit/cap, resulting in processor speed management in the manner described. For example, a high priority application **402** executing on a node **400** may require a "burst" of speed and thus, may be permitted to exceed certain limits as described above in the previous sections. When that happens, the central power controller **401** should ensure that the total power budget does not approach or exceed critical limits.

In other words, when a high priority application **402** is running at a higher speed, the total system power should still be below the power limit. If not, then the exception for the high priority application **402** should not be allowed-it too will execute at a slower rate. The power controller **400** thus may set the power limit with a certain amount of headroom from the mean power usage to permit higher speeds for high priority applications **402**. Alternatively or in addition, the power controller **400** may compensate for the increased power required by the high priority application **402** by reducing the speed of processors **320** at certain other parts of the system even further below the power limit.

Illustrative embodiments thus may eliminate the need for a hybrid cooling system. In fact, illustrative embodiments also may eliminate the need for an expensive chiller, which passes the cooling coils through a refrigerant to even more effectively cool the system in hot environments. Some data centers, for example, have both a wet cooling system and a somewhat redundant chiller to ensure that heating problems do not adversely impact system performance.

Many such systems, however, only need the power of a chiller for a few days a year. The rest of the time, a wet cooling system or even a dry cooling system may suffice. Despite that, absent use of various embodiments of the invention, operators of such systems unnecessarily incur the increased capital costs by acquiring the chiller.

In fact, many other high-performance computing systems often have a chiller as its sole source of cooling. While possibly reducing capital costs by only having one cooling source, those systems have higher incremental energy/operational costs than dry or wet cooling systems. Selectively reducing the processor speed therefore permits use of less expensive cooling sources, and eliminates the need for some redundant, standby cooling systems.

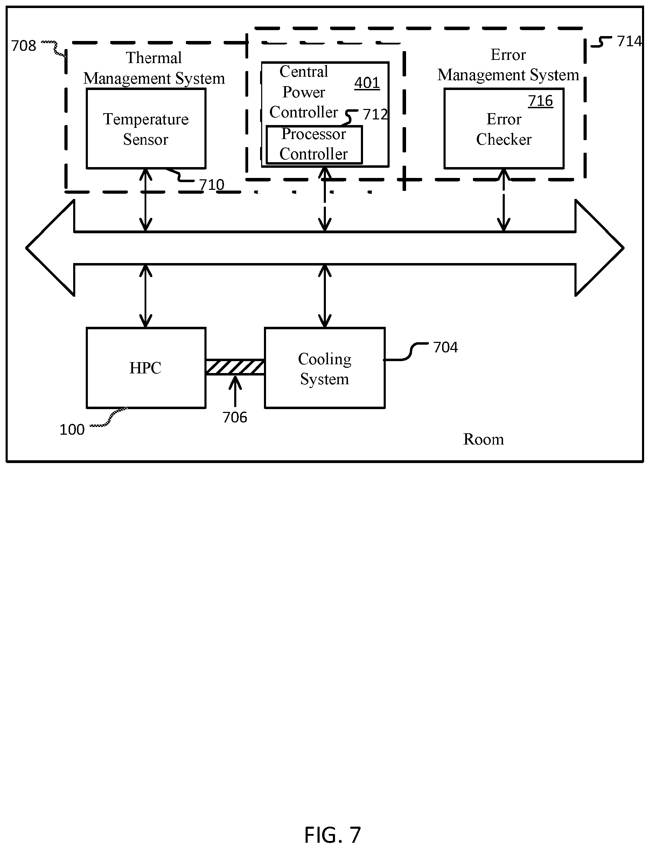

Those skilled in the art can implement this systemic thermal management using a number of processes and devices. To that end, FIG. 7 schematically shows a room **700** containing a high-performance computing systems and its attendant thermal management devices. It should be noted that this drawing may be considered to be another way of looking at the overall system shown in FIGS. 1-4.

Each of the components of FIG. 7 is operatively connected by any conventional interconnect mechanism. FIG. 7 simply shows a bus **702** communicating each the components. Those skilled in the art should understand that this generalized representation can be modified to include other conventional direct or indirect connections. Accordingly, discussion of a bus **702** is not intended to limit various embodiments.

Indeed, it should be noted that FIG. 7 only schematically shows each of the below discussed components. Those skilled in the art should understand that each of these components can be implemented in a variety of conventional manners, such as by using hardware, software, or a combination of hardware and software, across one or more other functional components. For example, the central power controller **401** may be implemented using a plurality of microprocessors executing firmware. As another example, the central power controller **401** may be implemented using one or more application specific integrated circuits (i.e., "ASICs") and related software, or a combination of ASICs, discrete electronic components (e.g., transistors), and microprocessors. Accordingly, the representation of the central power controller **401** and other components in a single box of FIG. 7 is for simplicity purposes only. In fact, in some embodiments, the central power controller **401** is distributed across a plurality of different devices-not necessarily within the same housing or chassis.

It should be reiterated that the representation of FIG. 7 is a significantly simplified representation of high-performance computing system components. Those skilled in the art should understand that the system and the shown sub-systems have many other physical and functional components not in this figure (but many shown in other figures), such as central processing units **320** and RAM **316**. Accordingly, this discussion is in no way intended to suggest that FIG. 7 represents all of the elements of an apparatus used in a high performance computing system.

Specifically, the system of FIG. 7 includes the noted high-performance computing system **100** physically and logically connected with the above noted cooling system (identified in FIG. 7 using reference number "**704**"). Accordingly, as noted above, the cooling system **704** has one or more coils **706**, filled with a refrigerant, such as water, that draw energy from the heat producing elements of the high-performance computing system. The cooling system **704** may externally cool these coils **706** by any of a number of means, such as those discussed above. Accordingly, the cooling system **704** has the above noted dry cooling mode, one or more additional wet cooling modes (e.g., one mode that sprays the coils **706** with water), and optionally another mode using a chiller.

In illustrative embodiments, a thermal management system **708** controls and coordinates the cooling system **704** and high-performance computing system to optimize cooling as a function of power drawn by the high-performance computing system. For example, as noted above, the thermal management system **708** may reduce processor speed of the high-performance computing system as a function of some environmental temperature, and/or change the mode of the cooling system **704**.

To those ends, the thermal management system **708** has a temperature sensor **710** that determines the temperature of some environmental condition (discussed below), and a processor controller **712** that interacts with the node managers **404** to control processor speed as a function of the determined temperature. In this example, the processor controller **712** is implemented as part of the central power controller **401** (FIG. 4). Other embodiments, however, may implement the processor controller **712** independently of the central power controller **401**.

FIG. 7 also shows an error management system **714** that includes the central power controller **401**, its processor controller **712**, and an error checker **716** that detects certain prescribed error conditions. In a manner similar to the thermal management system **708** and discussed in greater detail below in the "System Robustness" section, the error management system **714** controls processor speed as a function of detected correctable errors.

The room **700** may be any conventional building or edifice conventionally housing high-performance computing systems. For example, the room **700** may be a climate controlled data center that manages high-performance computing systems of various commercial, scientific, and/or industrial entities. Although not shown, the coils **706** may extend outside of the room **700** to another room, or outside of the building containing the room **700**.

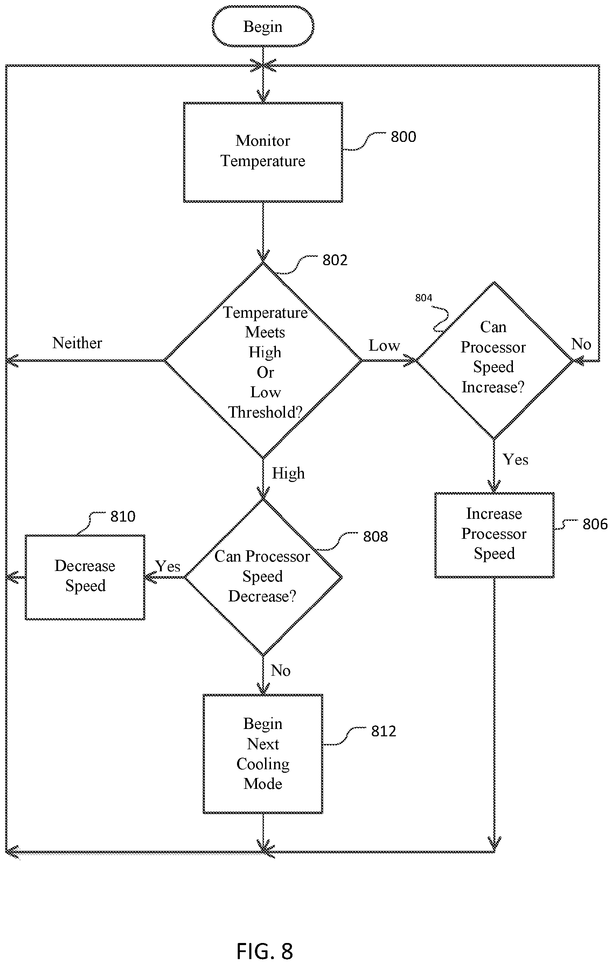

FIG. 8 shows a process of managing the thermal profile of the high-performance computing system in accordance with illustrative embodiments of the invention. In a manner similar to FIG. 6, it should be noted that this process is substantially simplified from a longer process that normally would be used to manage power use by the nodes **400**. Accordingly, the process can have many steps, such as specific techniques for formulate appropriate power levels, which those skilled in the art likely would use. In addition, some of the steps may be performed in a different order than that shown, or at the same time. Those skilled in the art therefore can modify the process as appropriate.

The process begins at step **800**, in which the temperature sensor **710** monitors the temperature of some environment or device related to the high-performance computing system. To that end, the temperature sensor **710** may collaborate with the node managers **404**, retrieve the temperature data independently of the node managers **404**, or rely exclusively on data from the node managers **404**. In some embodiments, step **800** monitors the temperature of the room **700** housing the high-performance computing system. For example, the temperature sensor **710**, which may include a plurality of separate temperature sensors **710** at different locations, may be positioned near the high-performance computing system. In that case, the temperature sensor **710** detects the air temperature of certain parts of the room **700**. Those skilled in the art can position the sensor(s) in appropriate locations based upon a number of factors, such as the proximity to the heat generating components of the high-performance computing system. Alternatively or additionally, the sensors may detect environmental conditions outside of the room **700**, such as in the environment outside of the building containing the room **700**.

Other embodiments may position the sensor(s) near or at specific components of the high-performance computing system. Among other things, the sensors may be positioned to sense the operating temperatures of some or all of the processors **320**, the memory (e.g., RAM cards **326** and RAM chips **326**), the hub ASIC **340**, and the power supplies **502**.

The central power controller **401** receives some or all of these temperature readings and then determines if it should change the power consumption of the processors **320**; i.e., if it should change the processing speed of the processors **320**. The process thus continues to step **802**, in which the central power controller **401** determines if the detected temperatures alone or together meet high or low prescribed temperature requirements.

Specifically, the central power controller **401** uses an algorithm to determine if it should change the processing speed. Among other ways, these algorithms may be developed using artificial intelligence, experimentation, empirical methods, and other similar techniques. In the simple case, the central power controller **401** may receive a single temperature value (e.g., the temperature in a region of the room **700**, or the temperature of one of the power supplies **502**) and compare it to prescribed upper and/or lower threshold values. If that single temperature value is greater than the prescribed upper threshold value, then the power controller **400** may reduce power consumption. Other embodiments, however, may use temperature readings from a number of different sensors (e.g., both the environmental temperature and a component temperature) to determine if the central power controller **401** should take action to increase or decrease power/processing speed.

For example, the central power controller **401** may receive temperature values from 15 different components and/or different regions of the room **700**, such as the processors **320**, power supplies **502**, and memory **326**. An internal algorithm may apply scaling factors and weightings to the different temperatures to determine if the aggregate temperature changes warrant a change in power consumption. A similar example may receive temperature values from the same 15 different components and/or different regions of the room **700**, and change power consumption if some prescribed number of those temperature values exceeds the range defined by the noted prescribed upper and lower threshold values. Both examples also may have a temporal component that requires the temperature to be outside of the noted range for a prescribed amount of time before taking action. Accordingly, this temporal approach can avoid system delay, jitter and other adverse effects of short-term positive or negative temperature spikes.

Accordingly, continuing with step **802**, the central power controller **401** determines if the temperature (i.e., the actual temperature value or a value produced as a function of the temperature values received from the temperature sensor(s) **710**) is within the above discussed prescribed temperature range. It should be noted that some embodiments do not have a lower temperature range. If the embodiment has a lower temperature threshold, and the temperature is below that low temperature threshold, then the process continues to step **804**, which determines if the processor speed can be increased. There are a number of reasons for not increasing the processor speed. Among other reasons, the processor **320** may be running at its maximum speed as set by the central power controller **401**, or it simply may not be able to run faster.

If the processor **320** cannot increase at speed, then the process loops back to monitor the relevant temperature(s) (step **800**). If, however, the processor **320** can increase its speed, then the processor controller **712** increases the processor speed by some amount (step **806**). Among other ways, the processor controller **712** may increase the speed of the processor **320** by a prescribed percentage, an absolute amount, to an increased speed, or as a function of other processes and requirements of the high-performance computing system **100**.

Among other ways, the processor controller **712** may increase the speed indefinitely, for up to a prescribed amount of time, or based on some other criteria. After the prescribed amount of time, the processor controller **712** may change the speed to another value, such as back to one or more earlier speeds at which the processor **320** executed, or at another speed as specified by the processor controller **712**. The selected amount of time nevertheless may be interrupted and thus, change if some other event necessitates a different change in processing speed (e.g., by a subsequent temperature change when iteratively executing the process of FIG. 8).

Returning to step **802**, if the temperature is within the range, then the process simply loops back to step **800** to monitor the relevant temperature(s). Finally, if step **802** determines that the temperature exceeds the high temperature threshold, then the process continues to step **808**, which determines if the processor speed can decrease. There are reasons for not decreasing speed despite the increased temperature. For example, as discussed above, a decrease of processor speed may adversely affect execution of an application **402** or other system functions. If the central power controller **401** determines that the processor speed can decrease, then its processor controller **712** forwards a speed reduction message to the appropriate nodes **400**, decreasing processor speed (step **810**). Among other ways, the processor controller **712** may decrease the speed of the processor **320** by a prescribed percentage, an absolute amount, to a reduced speed, or as a function of other processes and requirements of the high-performance computing system. It should be noted that the central power controller **400** can decrease the power in any convenient portion of the high performance computing system **100**.

In a manner similar to that discussed above with regard to step **806**, the processor controller **712** may decrease the speed indefinitely, up to a prescribed amount of time, or based on some other criteria. After the prescribed amount of time, the processor controller **712** may change the speed to another value, such as back to one or more earlier speeds at which the processor **320** executed, or at another speed as specified by the processor controller **712**. The selected amount of time nevertheless may be interrupted and thus, change if some other event necessitates different change in processing speed (e.g., by a subsequent temperature change when iteratively executing the process of FIG. 8).

The processor controller **712** also may decrease processing speed until the monitored temperature (or multi-temperature function of various different areas and/or over a prescribed time frame) decreases to a prescribed temperature. For example, the processor controller **712** may use a prescribed temperature value, and a certain tolerance, after which the processor speed may be increased while using the dry cooling mode, or a less water or energy intensive wet cooling mode.

The amount of time selected to decrease (or increase) the clock speeds can be determined based on a number of different techniques. Among others, those skilled in the art may use artificial intelligence, current and historical system data, and empirical experimental data.

After decreasing the processing speed at step **810**, the process loops back to step **800** to continue monitoring the relevant temperature(s). If, however, step **808** determines that the processor speeds cannot be decreased, then the process continues to step **812**, which begins the next cooling mode. For example, the process may change the mode of the cooling system **704** from a lower mode, such as a dry cooling mode, to a water intensive cooling mode, such as a wet cooling mode. Some embodiments may skip this step and simply send a warning or notice message to the system operators.

There also may be instances when the monitored temperature continues to rise despite reduced processing speeds. In that case, after reducing the processing speed to a lower speed in response to the monitored temperature, the central power controller **401** maintains the processing speed at the reduced amount and switches the cooling system **704** to a higher mode, from a dry cooling mode to a wet cooling mode-or even to a chiller. The processing speed may continue to be no greater than the reduced value for at least a portion of the time the cooling system **704** is in the wet cooling mode. As the coils **706** cool, however, the processing speed may be increased, or the cooling mode may switch back to a dry cooling mode.

Some embodiments may preemptively reduce processing speed as a function of the known cooling capacity of one of the cooling modes. For example, the central power controller **401** may determine that the cooling capacity of a lower cooling mode, such as a dry cooling mode, requires a prescribed maximum processing speed at certain times. If the processing speed is higher, then this lower cooling mode may not be able to adequately cool the system **100**. This determination may be made as a function of a number of variables, including time of day, historical performance of the high-performance computing system, executing applications **502**, etc. The central power controller **401** therefore may preemptively reduce the processing speeds to maintain the cooling system **704** and one or more lower, more efficient cooling modes.

The central power controller **401** also may monitor the health of the cooling system **704**, and take appropriate action if it detects a malfunction with the cooling system **704**. For example, after detecting a malfunction in the cooling system **704**, such as full cooling system failure, the central power controller **401** may reduce processing speeds to a level that can tolerate the lost cooling functionality, and/or turn off the cooling system **704**. Of course, a cooling system malfunction does not necessarily eviscerate complete cooling functionality. Some malfunctions may eviscerate certain cooling modes, or decrease the efficiency of certain modes. For example, if the central power controller **401** detects that the wet cooling modes are not functioning, then its processor controller **712** may preemptively reduce processing speeds to accommodate the more efficient but less effective dry cooling modes. As another example, if the central power controller **401** detects that the dry cooling mode is not functioning but the wet mode is functioning appropriately, then its processor controller **712** may increase processing speeds to take advantage of the increased cooling capacity of the wet cooling mode.

In a similar manner, some embodiments of the central power controller **401** may have tools to detect a potential upcoming failure in the cooling system **704**. For example, the cooling system **704** may behave in a certain way indicative of impending failure or malfunction. In that case, the central power controller **401** may preemptively reduce the processing speed to avoid a potential catastrophic systemic breakdown.

It should be noted that although processing speed changes were discussed on the node level, those skilled in the art may selectively change processing speeds among a subset of processors **320** on a single node **400**, or a subset of specific processors **320** across nodes **400**. Also like other embodiments discussed above, processing speed changes may be made across other levels, such as across the blade level, the rack level, system-level, or an entire data center level.

Accordingly, illustrative embodiments permit a user to use less expensive cooling alternatives. When the need arises, however (e.g., outside weather conditions exceed certain limits), then a system may switch to the next "level-up" in cooling capability. For example, when required, the system can change from 1) normally dry-cooling to the next level-up, which may be wet cooling, or 2) normal wet cooling to a chiller (i.e., the next level-up). Among other benefits, a user thus can acquire the next level-up cooling system **704** as backup for when weather conditions exceed limits (i.e., they can switch to the next level-up system in limited instances to save water and/or energy). Alternatively, a user can use only a single level cooling system **704** (i.e., not acquire the next level-up system as backup), thus saving capital costs.

### System Robustness

In a manner similar to other computer systems, high-performance computing systems are subject to failure, such as when an uncorrectable error occurs during runtime. Many errors that occur during runtime are correctable, however, and thus do not cause immediate system failure. For example, among others, those correctable errors may include certain types of memory errors, processor errors, or network errors.

The inventors recognized that system failure often is preceded by certain conditions, such as when the system experiences a relatively high number of correctable errors. The inventors also recognized that high-performance computing systems may be more prone to such errors when running its processors **320** at a high rate.

To meet this problem, the inventors discovered that they could reduce the speed of some or all of the processors **320** running on the high-performance computing system when logic on the system detects certain conditions. As noted above, those conditions may include detecting a prescribed number of correctable errors over a certain time, or a prescribed type of correctable error. Of course, those skilled in the art can reduce the processor speed upon detection other conditions. Discussion of certain numbers and types of correctable errors therefore is an example of one way of detecting a potential system problem and thus, is not intended to limit the system.

Accordingly, when the system detects the prescribed condition, logic may slow the processing speed of one or more processors **320** in the system **100**. The processing speeds can be controlled at the node level (e.g., within one or more of the processors **320** in a given node **400**), the blade level, the rack level, system-level, or an entire data center level. Those skilled in the art can select any of a number of ways to slow the processing speeds. For example, logic may slow the system down incrementally to a point where the number of current correctable errors is beneath a prescribed threshold. As a second example, however, logic may slow the system down to a prescribed speed (e.g., 10 percent or 15 percent of normal speed) until conditions meet certain normal requirements.

Some systems may reduce the speed until certain threads or processes have completed their execution. For example, a process may have been executing for two weeks and needs another day to complete processing (or another day to reach an appropriate stopping point). If the system slows down by ten percent, then that process may need another 1.1 days to complete processing. At this slower speed, the system should be less stressed and thus, more stable, reducing the likelihood that the system will fail before completion of this process. If the system were not to slow down, however, it would be more likely to fail, undesirably losing two weeks of processing. Increasing the processing time by such a small amount (relative to the total processing time) therefore can yield substantial benefits.

After the process in the above example has completed executing, or the system has met some other prescribed criteria, some or all of the system may be shut down so that a technician may repair the source of the errors. Alternatively, rather than shutting down the system, to repair the source of the errors, some systems may hot-swap specific portions of the system.

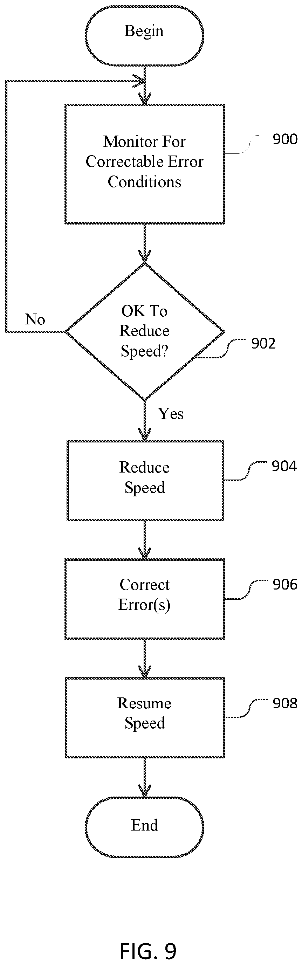

To those ends, FIG. 9 shows a process of managing errors of the high-performance computing system **100**. This process preferably is performed by the error management system **714**. In a manner similar to FIGS. 6 and 8, this process is substantially simplified from a longer process that normally would be used to manage errors of the high performance computing system **100**. Accordingly, the process can have many steps, such as specific techniques for formulating appropriate power levels, which those skilled in the art likely would use. In addition, some of the steps may be performed in a different order than that shown, or at the same time. Those skilled in the art therefore can modify the process as appropriate.

The method begins at step **900**, in which the error checker **716** monitors some or all of the high performance computing system **100** for any of a plurality of correctable error conditions. As noted above, these errors may include any of a wide variety of prescribed or un-prescribed correctable error conditions. For example, those error conditions may include memory correctable errors and network correctable errors detected by incorrect checksums or hash functions. Rather than directly detecting error conditions, however, some systems may indirectly detect evidence of error conditions. For example, elevated temperatures of certain system components, such as that of a processor **320**, a power supply **502**, or a memory chip **326**, can indicate a high likelihood of an error condition.

Regardless of the mode of detecting errors, the central power controller **401** has a prescribed set of rules and/or algorithms for determining whether a correctable error warrants processor speed reductions. Among other ways, these algorithms may be developed using artificial intelligence, experimentation, empirical methods, current system performance, and other similar techniques. For example, the central power controller **401** may score various error conditions on a weighted scale, add up the weighted values, and determine if the sum of those weights exceeds a prescribed threshold value. As a second example, the central power controller **401** may have specific error conditions that, regardless of weightings or algorithms, require a reduction in processor speed. As yet another example, the central power controller **401** may reduce speeds simply based on the aggregate total number of correctable errors in the entire system **100**, or on a specific portion of the system **100**.

Accordingly, after detecting a correctable error condition, the central power controller **401** determines at step **902** if the processor speed may be reduced. For example, a critical application **402** may be executing on the node(s) **400** in question and cannot be disturbed. In that case, the process may loop back to step **900** to continue monitoring for error correctable conditions. The central power controller **401**, however, may take additional action at that point to ensure the operation of the system. For example, the central power controller **401** may selectively reduce power to other processors **320**, and/or send a warning message to a system user indicating the potential problem.

If the central power controller **401** determines that it may reduce processor speed, then the process continues to step **904**, which reduces the processor speeds in any of a variety of manners. Among other ways, the processor controller **712** may decrease the speed of the processor **320** by a prescribed percentage, an absolute amount, to a reduced speed, or as a function of other processes and requirements of the high performance computing system **100**.

In a manner similar to that discussed above with regard to FIG. 8, the processor controller **712** may decrease the speed indefinitely, up to or for a prescribed time, or based on some other criteria. After the prescribed time, the processor controller **712** may change the speed to another value, such as back to one or more earlier speeds at which the processor **320** executed, or at another speed as specified by the processor controller **712**. The selected amount of time nevertheless may be interrupted and thus, change if some other event necessitates different change in processing speed (e.g., by a subsequent change when iteratively executing the process of FIG. 8).

The processor controller **712** also may decrease the speed until the monitored temperature decreases to a prescribed temperature. The amount of time selected to decrease the processing speeds can be determined based on a number of different techniques. Among others, those skilled in the art may use artificial intelligence, current and historical system data, and empirical experimental data.

Importantly, the processing speeds are slowed both for a time period and at a speed that should optimally ensure system effectiveness-reducing the likelihood of system failure.

After reducing the speed, the process continues to step **906**, in which logic or an operator corrects the located errors. Among other ways, the system can run with the (selected) processors **320** executing at a reduced speed until a technician can shut down the system and fix or replace potentially damaged or damaged components. Alternatively, the system can run with the noted processors **320** at their reduced rate until a technician can fix the errors by a hot swap or similar technique. For example, the technician may hot-swap certain boards having defective components with new boards having uncorrupted, similar components.

The process concludes at step **908** by resuming processing speeds to the normal state.

Accordingly, reducing microprocessor speed in this manner provides the system with a better chance of executing to a later point in time where remedial actions can be taken without substantial usage disruption.

Various embodiments of the invention may be implemented at least in part in any conventional computer programming language. For example, some embodiments may be implemented in a procedural programming language (e.g., "C"), or in an object oriented programming language (e.g., "C++"). Other embodiments of the invention may be implemented as a pre-configured, stand-along hardware element and/or as preprogrammed hardware elements (e.g., application specific integrated circuits, FPGAs, and digital signal processors), or other related components.

In an alternative embodiment, the disclosed apparatus and methods (e.g., see the various flow charts described above) may be implemented as a computer program product for use with a computer system. Such implementation may include a series of computer instructions fixed either on a tangible, non-transitory medium, such as a computer readable medium (e.g., a diskette, CD-ROM, ROM, or fixed disk). The series of computer instructions can embody all or part of the functionality previously described herein with respect to the system.

Those skilled in the art should appreciate that such computer instructions can be written in a number of programming languages for use with many computer architectures or operating systems. Furthermore, such instructions may be stored in any memory device, such as semiconductor, magnetic, optical or other memory devices, and may be transmitted using any communications technology, such as optical, infrared, microwave, or other transmission technologies.

Among other ways, such a computer program product may be distributed as a removable medium with accompanying printed or electronic documentation (e.g., shrink wrapped software), preloaded with a computer system (e.g., on system ROM or fixed disk), or distributed from a server or electronic bulletin board over the network (e.g., the Internet or World Wide Web). In fact, some embodiments may be implemented in a software-as-a-service model ("SAAS") or cloud computing model. Of course, some embodiments of the invention may be implemented as a combination of both software (e.g., a computer program product) and hardware. Still other embodiments of the invention are implemented as entirely hardware, or entirely software.

Although the above discussion discloses various exemplary embodiments of the invention, it should be apparent that those skilled in the art can make various modifications that will achieve some of the advantages of the invention without departing from the true scope of the invention defined in the claims.

## Claims

1. A system comprising a high performance computing system (100), a cooling system (704), and an apparatus (708) for thermally managing the high performance computing system, the high performance computing system (100) comprising:
a plurality of nodes (400) with microprocessors; the cooling system (704) comprising:
a coil (706), wherein the cooling system (704) is configured to selectively cool the coil (706) in any one of a plurality of modes, the modes including a dry cooling mode that blows air on the coil (706) and a wet cooling mode that sprays the coil (706) with water, whereby the coil (706) draws energy from the heat producing elements of the high-performance computing system (100);
the apparatus (708) comprising:
a temperature sensor (710) configured to monitor the temperature of at least one of a) the environment of the high performance computing system (100) and b) at least a portion of the high performance computing system (100); and
a controller (401) operatively coupled with the temperature sensor (710), the controller (401) being configured to control the processing speed of at least one of the microprocessors on at least one of the plurality of nodes as a function of at least one of the monitored temperatures, the controller being configured to reduce the processing speed to a lower speed in response to the monitored temperature exceeding a high temperature threshold and convectively cool the coil (706) with the dry cooling mode, and after reducing the processing speed and using the dry cooling mode, switch the cooling system (704) to the wet cooling mode and conductively cool the coil (706) with the wet cooling mode if the monitored temperature continues to rise and exceeds a prescribed amount such that the dry cooling mode was not able to cool the coil (706) sufficiently given certain performance parameters, the processing speed when using the wet cooling mode being no greater than the lower speed.

2. The system of claim 1 wherein at least one of the nodes also includes memory and a power supply, the portion of the high performance computing system (100) comprising at least one of the microprocessors, memory, and power supplies.

3. The system of claim 1 wherein the temperature sensor (710) is configured to monitor the temperature of both a) the environment of the high performance computing system (100) and b) at least the portion of the high performance computing system (100),
the controller (401) being configured to control the processing speed of at least one of the microprocessors on at least one of the plurality of nodes as a function of both the monitored temperatures (a) and (b).

4. A method of thermally managing the high performance computing system (100) of the system of claim 1, the method comprising:
monitoring (800) the temperature of at least one of a) the environment of the high performance computing system (100) and b) at least a portion of the high performance computing system (100);
controlling the processing speed of at least one of the microprocessors on at least one of the plurality of nodes as a function of at least one of the monitored temperatures;
reducing (810) the processing speed to a lower speed in response to the monitored temperature exceeding a high temperature threshold, and convectively cooling the coil (706) with the dry cooling mode;
after reducing the processing speed and using the dry cooling mode, switching the cooling system (704) to the wet cooling mode and conductively cooling the coil (706) with the wet cooling mode if the monitored temperature continues to rise and exceeds a prescribed amount such that the dry cooling mode was not able to cool the coil (706) sufficiently given certain performance parameters, the processing speed when using the wet cooling mode being no greater than the lower speed.

5. The method of claim 4, wherein the high performance computing system (100) is within a room (700) having an air temperature, the environment comprising a region of the room (700), the temperature being the air temperature at the region of the room (700).

6. The method of claim 4, wherein at least one of the nodes (400) also includes memory and a power supply, the portion of the high performance computing system comprising at least one of the microprocessors, memory, and power supplies.

7. The method of claim 4, wherein monitoring the temperature comprises monitoring the temperature of both a) the environment of the high performance computing system (100) and b) at least the portion of the high performance computing system (100).

8. The method as defined by claim 7, wherein controlling comprises controlling the processing speed of at least one of the microprocessors on at least one of the plurality of nodes (400) as a function of both the monitored temperatures (a) and (b).

9. The method as defined by claim 4 wherein controlling comprises:
reducing (810) the processing speed of the at least one microprocessor at least until the monitored temperature decreases to a prescribed temperature; and
increasing (806) the processing speed of the at least one microprocessor after the monitored temperature has decreased to the prescribed temperature.

## Patentansprüche

1. System, umfassend ein Hochleistungscomputersystem (100), ein Kühlsystem (704) und eine Vorrichtung (708) zum thermischen Management des Hochleistungscomputersystems,
wobei das Hochleistungscomputersystem (100) umfasst:
eine Vielzahl von Knoten (400) mit Mikroprozessoren;
wobei das Kühlsystem (704) umfasst:
eine Spule (706), worin das Kühlsystem (704) dafür konfiguriert ist, die Spule (706) selektiv in einem von einer Vielzahl von Modi zu kühlen, wobei die Modi einen Trockenkühlmodus, der Luft auf die Spule (706) bläst, und einen Nasskühlmodus, der die Spule (706) mit Wasser besprüht, einschließen, wodurch die Spule (706) Energie von den wärmeerzeugenden Elementen des Hochleistungscomputersystems (100) abzieht;
wobei die Vorrichtung (708) umfasst:
einen Temperatursensor (710), der dafür konfiguriert ist, die Temperatur von mindestens einem von a) der Umgebung des Hochleistungscomputersystems (100) und b) mindestens einem Abschnitt des Hochleistungscomputersystems (100) zu überwachen; und
ein Steuerungssystem (401), das betrieblich mit dem Temperatursensor (710) gekoppelt ist, wobei das Steuerungssystem (401) dafür konfiguriert ist, die Verarbeitungsgeschwindigkeit von mindestens einem der Mikroprozessoren auf mindestens einem der Vielzahl von Knoten als Funktion von mindestens einer der überwachten Temperaturen zu steuern, wobei das Steuerungssystem dafür konfiguriert ist, als Antwort darauf, dass die überwachte Temperatur einen hohen Temperaturschwellenwert überschreitet, die Verarbeitungsgeschwindigkeit auf eine niedrigere Geschwindigkeit zu verringern und die Spule (706) mit dem Trockenkühlmodus konvektiv zu kühlen, und nach dem Verringern der Verarbeitungsgeschwindigkeit und Verwenden des Trockenkühlmodus das Kühlsystem (704) auf den Nasskühlmodus umzuschalten und die Spule (706) mit dem Nasskühlmodus konduktiv zu kühlen, wenn die überwachte Temperatur weiterhin ansteigt und einen vorgeschriebenen Betrag überschreitet, sodass der Trockenkühlmodus nicht imstande war, die Spule (706) unter Berücksichtigung bestimmter Leistungsparameter ausreichend zu kühlen, wobei die Verarbeitungsgeschwindigkeit, wenn der Nasskühlmodus verwendet wird, nicht größer als die niedrigere Geschwindigkeit ist.

2. System nach Anspruch 1, worin mindestens einer der Knoten auch einen Arbeitsspeicher und eine Stromversorgung einschließt, wobei der Abschnitt des Hochleistungscomputersystems (100) mindestens eines von Folgendem umfasst: die Mikroprozessoren, der Arbeitsspeicher und die Stromversorgungen.

3. System nach Anspruch 1, worin der Temperatursensor (710) dafür konfiguriert ist, die Temperatur sowohl a) der Umgebung des Hochleistungscomputersystems (100) als auch b) mindestens des Abschnitts des Hochleistungscomputersystems (100) zu überwachen,
wobei das Steuerungssystem (401) dafür konfiguriert ist, die Verarbeitungsgeschwindigkeit von mindestens einem der Mikroprozessoren auf mindestens einem der Vielzahl von Knoten als Funktion beider überwachten Temperaturen (a) und (b) zu steuern.

4. Verfahren zum thermischen Management des Hochleistungscomputersystems (100) des Systems nach Anspruch 1, wobei das Verfahren umfasst:
Überwachen (800) der Temperatur von mindestens einem von a) der Umgebung des Hochleistungscomputersystems (100) und b) mindestens einem Abschnitt des Hochleistungscomputersystems (100);
Steuern der Verarbeitungsgeschwindigkeit von mindestens einem der Mikroprozessoren auf mindestens einem der Vielzahl von Knoten als Funktion von mindestens einer der überwachten Temperaturen;
Verringern (810) der Verarbeitungsgeschwindigkeit auf eine niedrigere Geschwindigkeit als Antwort darauf, dass die überwachte Temperatur einen hohen Temperaturschwellenwert überschreitet, und konvektives Kühlen der Spule (706) mit dem Trockenkühlmodus;
nach dem Verringern der Verarbeitungsgeschwindigkeit und Verwenden des Trockenkühlmodus erfolgendes Umschalten des Kühlsystems (704) auf den Nasskühlmodus und konduktives Kühlen der Spule (706) mit dem Nasskühlmodus, wenn die überwachte Temperatur weiterhin ansteigt und einen vorgeschriebenen Betrag überschreitet, sodass der Trockenkühlmodus nicht imstande war, die Spule (706) unter Berücksichtigung bestimmter Leistungsparameter ausreichend zu kühlen, wobei die Verarbeitungsgeschwindigkeit, wenn der Nasskühlmodus verwendet wird, nicht größer als die niedrigere Geschwindigkeit ist.

5. Verfahren nach Anspruch 4, worin das Hochleistungscomputersystem (100) sich in einem Raum (700) mit einer Lufttemperatur befindet, wobei die Umgebung einen Bereich des Raums (700) umfasst und die Temperatur die Lufttemperatur in dem Bereich des Raums (700) ist.

6. Verfahren nach Anspruch 4, worin mindestens einer der Knoten (400) auch einen Arbeitsspeicher und eine Stromversorgung einschließt, wobei der Abschnitt des Hochleistungscomputersystems mindestens eines von Folgendem umfasst: die Mikroprozessoren, der Arbeitsspeicher und die Stromversorgungen.

7. Verfahren nach Anspruch 4, worin das Überwachen der Temperatur umfasst: Überwachen der Temperatur sowohl a) der Umgebung des Hochleistungscomputersystems (100) als auch b) mindestens des Abschnitts des Hochleistungscomputersystems (100).

8. Verfahren nach Anspruch 7, worin das Steuern umfasst: Steuern der Verarbeitungsgeschwindigkeit von mindestens einem der Mikroprozessoren auf mindestens einem der Vielzahl von Knoten (400) als Funktion beider überwachten Temperaturen (a) und (b).

9. Verfahren nach Anspruch 4, worin das Steuern umfasst:
Verringern (810) der Verarbeitungsgeschwindigkeit des mindestens einen Mikroprozessors mindestens so lange, bis die überwachte Temperatur auf eine vorgeschriebene Temperatur sinkt; und
Erhöhen (806) der Verarbeitungsgeschwindigkeit des mindestens einen Mikroprozessors, nachdem die überwachte Temperatur auf die vorgeschriebene Temperatur gesunken ist.

## Revendications

1. Système comprenant un système informatique hautes performances (100), un système de refroidissement (704) et un appareil (708) permettant de gérer thermiquement le système informatique hautes performances, le système informatique hautes performances (100) comprenant :
une pluralité de nœuds (400) avec des microprocesseurs ;
le système de refroidissement (704) comprenant :
une bobine (706), dans lequel le système de refroidissement (704) est configuré pour refroidir sélectivement la bobine (706) dans l'un quelconque d'une pluralité de modes, les modes incluant un mode de refroidissement à sec qui souffle de l'air sur la bobine (706), et un mode de refroidissement humide qui vaporise la bobine (706) avec de l'eau, moyennant quoi la bobine (706) extrait de l'énergie des éléments producteurs de chaleur du système informatique hautes performances (100) ;
l'appareil (708) comprenant :
un capteur de température (710) configuré pour surveiller la température d'au moins un de a) l'environnement du système informatique hautes performances (100) et b) au moins une partie du système informatique hautes performances (100) ; et
un système de commande (401) couplé opérationnellement avec le capteur de température (710), le système de commande (401) étant configuré pour commander la vitesse de traitement d'au moins un des microprocesseurs sur au moins une de la pluralité de nœuds en fonction d'au moins une des températures surveillées, le système de commande étant configuré pour réduire la vitesse de traitement à une vitesse inférieure en réponse au dépassement par la température surveillée d'un seuil de température élevé et pour refroidir par convection la bobine (706) en mode de refroidissement à sec, et après réduction de la vitesse de traitement et utilisation du mode de refroidissement à sec, commuter le système de refroidissement (704) en mode de refroidissement humide, et refroidir par conduction la bobine (706) en mode refroidissement humide, si la température surveillée continue d'augmenter et dépasse une valeur prescrite, de sorte que le mode de refroidissement à sec n'a pas été capable de refroidir suffisamment la bobine (706) compte tenu de certains paramètres de performances, la vitesse de traitement lors de l'utilisation du mode de refroidissement humide n'étant pas supérieure à la vitesse inférieure.

2. Système selon la revendication 1, dans lequel au moins un des nœuds inclut également une mémoire et une alimentation électrique, la partie du système informatique hautes performances (100) comprenant au moins un élément parmi les microprocesseurs, la mémoire et les alimentations électriques.

3. Système selon la revendication 1, dans lequel le capteur de température (710) est configuré pour surveiller la température à la fois a) de l'environnement du système informatique hautes performances (100) et b) d'au moins la partie du système informatique hautes performances (100),
le système de commande (401) étant configuré pour contrôler la vitesse de traitement d'au moins un des microprocesseurs sur au moins un de la pluralité de nœuds en fonction à la fois des températures surveillées (a) et (b).

4. Procédé de gestion thermique du système informatique hautes performances (100) du système selon la revendication 1, le procédé comprenant :
la surveillance (800) de la température d'au moins un de a) l'environnement du système informatique hautes performances (100) et b) au moins une partie du système informatique hautes performances (100) ;
le contrôle de la vitesse de traitement d'au moins un des microprocesseurs sur au moins un de la pluralité de nœuds en fonction d'au moins une des températures surveillées ;
la réduction (810) de la vitesse de traitement à une vitesse inférieure en réponse au dépassement par la température surveillée d'un seuil de température élevé, et le refroidissement par convection de la bobine (706) en mode de refroidissement à sec ;
après la réduction de la vitesse de traitement et l'utilisation du mode de refroidissement à sec, la commutation du système de refroidissement (704) en mode de refroidissement humide et le refroidissement par conduction de la bobine (706) en mode de refroidissement humide si la température surveillée continue d'augmenter et dépasse une valeur prescrite, de sorte que le mode de refroidissement à sec n'a plus été capable de refroidir suffisamment la bobine (706) compte tenu de certains paramètres de performances, la vitesse de traitement lors de l'utilisation du mode de refroidissement humide ne dépassant pas la vitesse inférieure.

5. Procédé selon la revendication 4, dans lequel le système informatique hautes performances (100) est dans une pièce (700) présentant une température de l'air, l'environnement comprenant une région de la pièce (700), la température étant la température de l'air dans la région de la pièce (700).

6. Procédé selon la revendication 4, dans lequel au moins un des nœuds (400) inclut également une mémoire et une alimentation électrique, la partie du système informatique hautes performances comprenant au moins un élément parmi les microprocesseurs, la mémoire et les alimentations électriques.

7. Procédé selon la revendication 4, dans lequel la surveillance de la température comprend la surveillance de la température à la fois a) de l'environnement du système informatique hautes performances (100) et b) au moins de la partie du système informatique hautes performances (100).

8. Procédé selon la revendication 7, dans lequel le contrôle comprend le contrôle de la vitesse de traitement d'au moins un des microprocesseurs sur au moins un de la pluralité de nœuds (400) en fonction à la fois des températures surveillées (a) et (b).

9. Procédé selon la revendication 4, dans lequel le contrôle comprend :
la réduction (810) de la vitesse de traitement du au moins un microprocesseur au moins jusqu'à ce que la température surveillée baisse à une température prescrite ; et
l'augmentation (806) de la vitesse de traitement du au moins un microprocesseur après que la température surveillée a baissé à la température prescrite.
